# EUROPEAN PATENT SPECIFICATION

(11) **EP 2 168 748 B1**
(45) Date of publication and mention of the grant of the patent: **17.11.2010**
(21) Application number: 08165108.5
(22) Date of filing: 25.09.2008
(51) Int. Cl.: B29C 45/00, B29C 45/16, F21V 15/01, F21V 23/06, F21V 31/00, H01R 4/04

(54) **A watertight lamp and a manufacturing method thereof**
Wasserdichte Lampe und Herstellungsverfahren dafür
Lampe étanche et son procédé de fabrication

(43) Date of publication of application: 31.03.2010
(73) Proprietor: Hella Lighting Finland Oy, 24280 Salo (FI)
(72) Inventor: Yllikäinen, Sami, 24280, Salo (FI)
(74) Representative: Roitto, Klaus

(56) References cited:
- DE-T5-112006 000 583
- US-A1- 2004 036 417

## Description

### FIELD OF THE INVENTION

The present invention relates to a method for manufacturing a watertight lamp comprising a housing, a lens attached to the housing, an electric component unit comprising a light source, and an outer connector for connecting a power supply to the lamp, the method comprising the steps of injection moulding the lens, injection moulding the housing, inserting the electric component unit into the housing, and attaching the lens to the housing in a watertight manner.

The present invention relates also to a watertight lamp comprising a housing, a lens attached watertight to the housing, an electric component unit comprising a light source, and an outer connector for connecting a power supply to the lamp.

### BACKGROUND OF THE INVENTION

A method and a lamp of the aforementioned kind are known e.g. from the automotive industry when manufacturing signal lamps for vehicles.

Conventionally such lamps are manufactured by injection moulding the housing and the lens of the lamp in separate moulds of separate moulding machines. After the housing and the lens have been moulded, the electric component unit and outer metallic connectors are mounted to the housing. Thereafter the lens is attached to the housing either by screws, gluing, hot plate welding, vibration welding or by ultrasonic welding. Finally the outer connector is sealed so that the lamp becomes watertight.

The above manufacturing steps are time consuming and require much floor area of the mounting site owing to the use of separate moulding machines and owing to the need to displace the different parts of the lamp on a wide area during the manufacturing process.

DE 11 2006 000 583 T5 discloses a method and a lamp of the aforementioned kind. In the method the housing, the lens and the sealing are moulded in a common mould having three cavities. The method comprises:
- a first moulding step comprising feeding a first plastic compound into a first cavity of a mould comprising at least three cavities and a second moulding step comprising feeding a second plastic compound into a second cavity of the mould and producing by said moulding steps the injection moulded housing and the injection moulded lens, respectively, of the lamp,
- opening the mould and inserting in the housing the electric component unit comprising the light source,
- closing the mould, and
- a moulding step comprising feeding a sealing compound into a third cavity of the mould and thus producing a seal which attaches the lens to the housing in a watertight manner.

US 2004/076417 A1 discloses a lamp assembly wherein an electroconductive compound is used for connecting a connector to the light emitting source.

### BRIEF DESCRIPTION OF THE INVENTION

An object of the present invention is to provide a method which solves the above mentioned problems and enables a very quick manufacturing process for a lamp of the aforementioned kind. This object of the invention is achieved by a method having the features defined in the attached claim 1. The invention is especially characterized by producing in a moulding step conductive parts of the outer connector to the lamp by feeding into the closed mould an electro conductive compound comprising a polymer, said conductive parts providing an electro conductive path from the connector to the electric component unit. The term electro conductive compound means here a compound which comprises a polymer and which conducts electricity.

Preferably the manufacturing of the lamp is made totally automatic whereby preferably a robot is used for inserting the electric component unit into the housing.

Preferably the electro conductive compound is a thermoplastic mixed with copper fibres.

If the electric component unit is of such a type that it heats up, e.g. owing to the use of a light source having high power consumption, the method preferably comprises a further moulding step comprising feeding a thermally conductive compound to the lamp and thus producing a cooling member attached to the electric component unit for cooling the electric component unit, said cooling member comprising a heat emitting surface, said further moulding step preceding the fourth moulding step.

Preferably ABS is chosen as the plastic compound for the housing and PMMA is chosen as the plastic compound for the lens.

Preferable embodiments of the method are disclosed in the attached dependent claims 2-6.

The most important advantages of the method of the invention is that it enables a very fast manufacturing of a lamp said manufacturing needing only little floor area at the manufacturing site. Further, it makes it possible to manufacture the lamp fully automatically.

An object of the invention is also to provide a lamp of the aforementioned kind and the construction of which enables a very fast manufacturing requiring very little floor area at the manufacturing site. For this purpose the lamp according to the invention is characterized in that the outer connector comprises conductive parts of electro conductive compound comprising a polymer, said conductive parts providing an electro conductive path to the electric component unit.

Preferably it comprises electro conductive paths made of electro conductive compound comprising a polymer, said electro conductive paths being positioned between the conductive parts of the connector and the electric component unit for electrically connecting the former to the latter.

If the electric component unit of the lamp is of such a type that it generates much heat the lamp preferably comprises a cooling member made of a thermally conductive compound and attached to the electric component unit for cooling the electric component unit, said cooling member comprising a heat emitting area.

Preferred embodiments of the lamp are disclosed in the attached dependent claims 8-15.

The most important advantages of the lamp according to the invention is that the manufacturing thereof is very fast and requires only little floor area at the manufacturing site. The outer design of the lamp can also be chosen very freely.

### BRIEF DESCRIPTION OF THE DRAWINGS

In the following the invention will be described in greater detail by means of preferred embodiments with reference to the attached drawings, in which
figure 1 shows a first embodiment of a lamp according to the invention seen from the lens side,
figure 2 shows the lamp in figure 1 seen from the side;
figure 3 shows the lamp in figure 1 seen from below;
figure 4 shows the lamp in an exploded view and illustrates the main components of the lamp;
figure 5 illustrates the manufacturing process according to the invention;
figures 6 and 7 illustrate a second embodiment of the lamp according to the invention seen from the lens side and from below, respectively;
figure 8 illustrates a sectional view of an enlarged detail of the lamp in figures 6 and 7; and
figures 9-11 show a third embodiment of the lamp according to the invention.

### DETAILED DESCRIPTION OF THE INVENTION

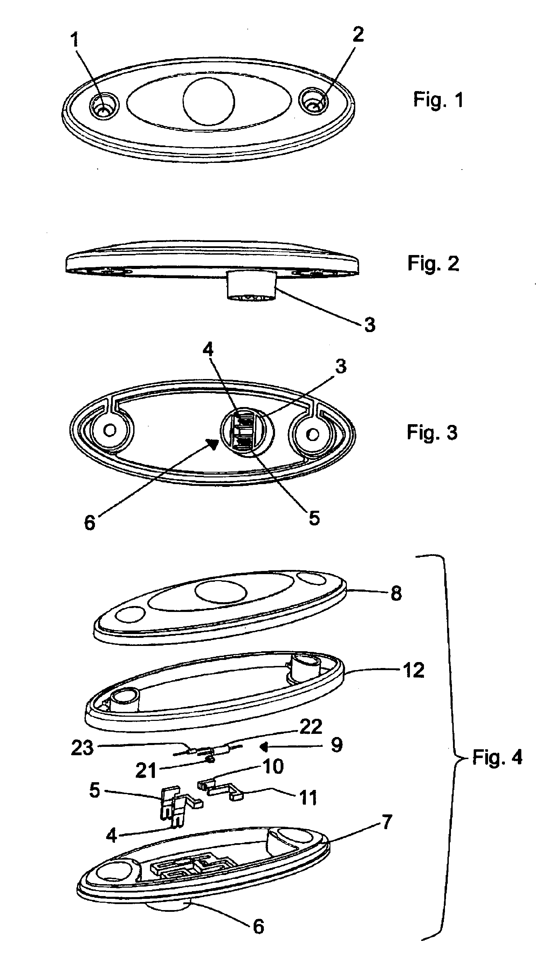

Figure 1 shows a lamp of the invention seen from the front, i.e. from the lens side. The lamp comprises two apertures 1, 2 for mounting the lamp to a wall or other structure.

In figures 2 and 3, where the lamp is shown in a side view and from below, respectively, one can see the outer connector 6 of the lamp. The connector 6 comprises conductive parts formed of two pins 4, 5 of electrically conductive material. The pins 4, 5 are surrounded by a guide structure, generally designated with reference numeral 3 and having a circular periphery which encloses partition walls which surround the pins 4, 5.

Figure 4 is a exploded view showing the components of the lamp. The base or housing is designated with reference numeral 7. The lens is designated with reference numeral 8. An electric component unit is designated with reference numeral 9. Electro conductive parts are designated 4, 5, 10 and 11. The sealing which is for hermetically sealing the housing 7 to the lens 8 is designated 12.

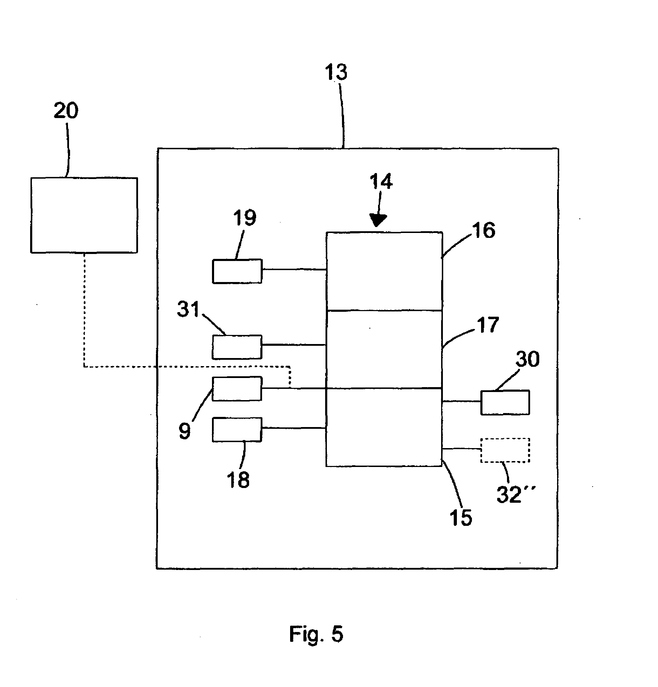

In the following is disclosed, by referring to figure 5, the manufacturing process of the lamp shown in figures 1-3.

In figure 5 reference numeral 13 schematically represents a 3-component injection moulding machine. If a lamp with a more sophisticated structure is to be manufactured one can use a 4-component injection moulding machine.

The moulding machine 13 comprises a mould 14 comprising a first cavity 15, a second cavity 16 and a third cavity 17.

In a first moulding step ABS (acrylonitrile butadiene styrene) plastic 18 is fed (injected) into the first cavity 15 of the mould 14. The housing 7 of the lamp is manufactured in the first cavity 15. In a second moulding step PMMA (polymethyl methacrylate plastic is fed (injected) into the second cavity 16 of the mould 14. The lens 8 of the lamp is manufactured in the second cavity 16. The lens 8 and the housing 7 are preferably manufactured at the same time, i.e. ABS plastic and PMMA plastic are simultaneously fed into respective cavities. Although these materials are preferable, one could use instead e.g. a polycarbonate, PC, as the material for the housing and/or the lens. The mould 14 is kept closed during the manufacture of the housing 7 and the lens 8. The mould 14 is next opened and a robot 20 is used to insert the electric component unit 9 in the housing 7. The components of the electric component unit 9 are positioned separately into a fixed half of the mould. The electric component unit comprises a LED 21, a resistor 22 and a diode 23, see figure 4. The mould 14 is closed and in a third moulding step an electro conductive compound 30 comprising a polymer is fed (injected) into the mould 14. The electro conductive compound is fed straight to the LED 21, the resistor 22, diode 23 and also to flow channels forming the pins 5, 6. The third moulding step provides electro conductive paths 10, 11 between the components 21, 22, 23 of the electric component unit and provides also an electro conductive path from the connector 6 to the electric component unit 9, and creates an electrical circuit. As electro conductive compound 30 one can use a thermoplastic combined with copper fibre and a low melting alloy. Here, the term thermoplastic includes thermoplastic elastomer (TPE) which is a thermoplastic having characteristics similar to rubber and which can repeatedly be reshaped. Nearly all commercially available thermoplastics (and thermoplastic elastomers) can be used as matrix material. The amount of copper fibre can be e.g. 55 w.-%, the amount of thermoplastic e.g. 15 w.-% and the amount of the low-melting alloy e.g. 30 w.-%. The low-melting alloy may advantageously be an alloy of led, bismuth and tin, e.g. HEK Low Melting Alloy MCP 96, Article number 10191384 from Siemens AG, having a melting temperature of about 96 °C. Such electro conducive compound is e.g. SCHULATEC®TinCo. In Europe this compound can be ordered from several countries including Great Britain, where the contact address is A. Schulman Inc. Ltd.; Croespenmaen Industrial Estate; Crumlin; Newport; GB-Gwent; NP11 3AG. In U.S.A. it can be ordered from A. Schulman Inc. ; Corporate Headquarters 3550 West Market Street; Akron; Ohio 44333; USA. The electrical conductivity of this compound SCHULATEC®TinCo is similar to steel (about 80 dB in the frequency range between 30 kHz and 1.2 GHz when the sample thickness is 1.5 mm). When the electro conductive compound is injected, the thermoplastic material and the low melting alloy are in molten liquid state. After the electro conductive compound has been moulded, a sealing compound 31, which can be ABS or PMMA, is fed in a fourth moulding step into the closed mould 14. The sealing compound 31 forms a sealing 12 which connects the lens 8 to the housing 7 in a watertight and hermetic manner.

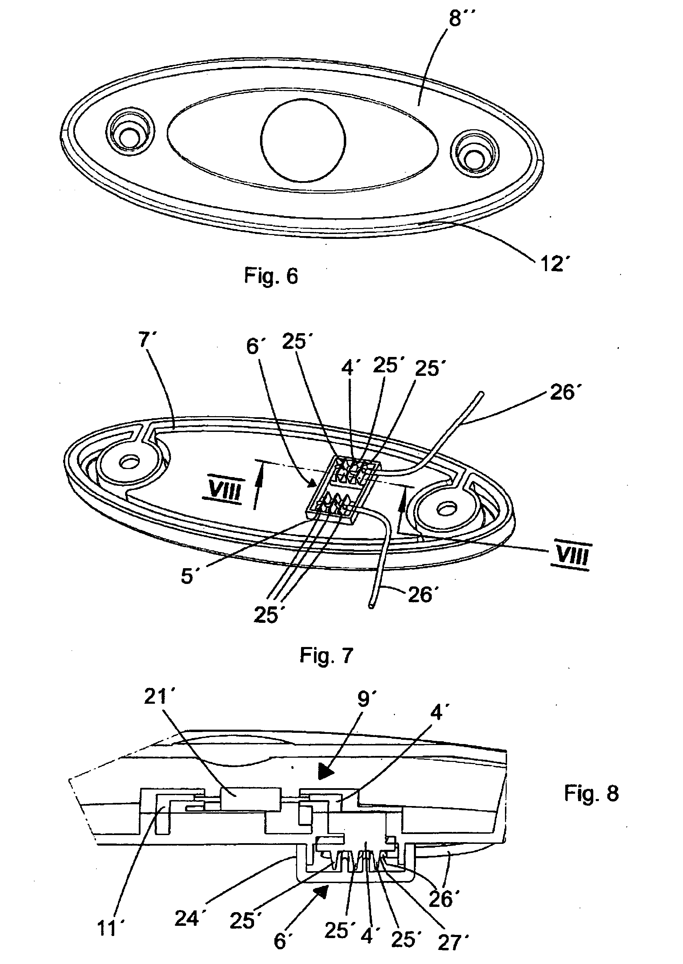

Figures 6-8 show a second embodiment of the lamp according to the invention seen from below. In the figures the corresponding reference numerals as in figures 1-4 have been used for corresponding components. Figure 6 shows the lamp from the front and figure 7 from below. Figure 6 illustrates a sectional view taken along line VIII-VIII in figure 7. Figure 7, however, does not show any lid 24' (seen in figure 8) on the connector 6 so that the connector better can be seen in the figure. The embodiment in figures 6-8 differs from the embodiment in figures 1-3 in that the conductive parts 4', 5' are designed in a different way. Each conductive part 4', 5' comprise three conductive members 25' forming a zigzag path for receiving a voltage supply wire 26'. Each member 25' comprises a slot 27' for receiving the wire 26' along the zigzag path. Said construction enables to connect the free end of the wire 26', as such, to the connector 6', i.e. without any need of an additional connector at the free end of the wire. The lid 24' which is attached to the connector 6' by pressing, comprises two protrusions which set into the grooves formed between the members 25' of the conductive parts 4', 5'. Instead of a lid 24' one may use glue or some other substance to secure the wire 26' to the connector 6'. The glue not only secures the wire 26' to the connector 6' but ensures also that the lamp will be hermetically sealed against its environment.

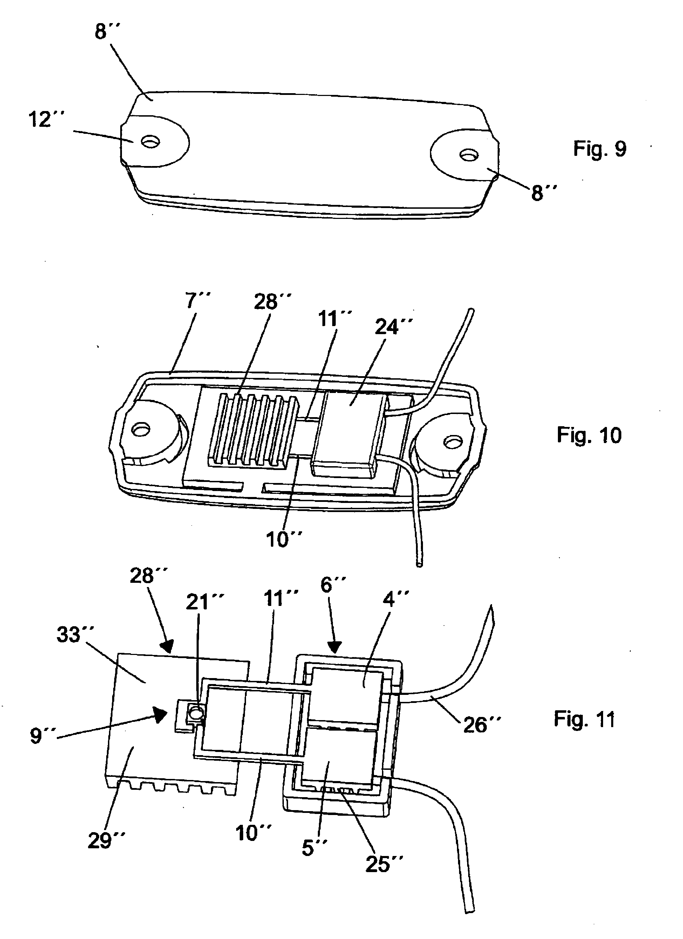

Figures 9-11 illustrate a third embodiment of the invention. The reference numerals used in figures 9-11 correspond to those used in figures 1-4 and 6-8 for corresponding parts. In figures 10 and 11 reference numeral 28" refers to a cooling member made of a thermally conductive compound (see 32" in figure 5) and having a heat emitting surface 33". The cooling member 28" is required if the electric component unit 9" of the lamp generates much heat. The compound 32" may have a similar composition as the electro conductive compound 30 used for the conductive parts of the connector (c.f. items 4, 5, 10 and 11 in Fig. 4). The more copper fibres the compound 32" contains, the better will be the thermal conductivity and cooling properties of the cooling member 28". By choosing the amount of copper in the compound 32" one may achieve a cooling member 28"' having the required cooling properties for each specific application. When attaching the cooling member 28" to the electric component unit 9" of the lamp one must arrange that no unwanted short circuits can take place. One way to avoid such short circuits is to apply a thin electrical insulation 29" between the cooling member 28" and the electro conductive parts 10", 11 ". The thickness of such an insulation is small, typically e.g. 0.01-0.03 mm; and in any case preferably less than 0.1 mm. Preferably the cooling member 28" is manufactured as a further moulding step comprising feeding thermally conductive compound 32" to the lamp before the sealing compound (31) is fed to the lamp.

In the embodiments shown in the figures no traditional circuit board having conductive paths is required, because such conductive paths have been replaced by conductive parts 10, 11 formed of the electro conductive compound 30, see figures 4, 8 and 11. Even traditional resistors are preferably replaced with the electro conductive compound 30, because the electro conductive compound gives rise to an electrical resistance. Thus, one may create with the electro conductive compound components functioning as resistors. This, however, does not mean that one cannot utilize a conventional printed circuit board.

All embodiments of the lamp are made complete in the moulding machine 13 in such a way that all moulding steps take place in the mould 14 where a complete and finished lamp is manufactured. However, the lamp illustrated in figures 9-11 may be manufactured in such a way that the cooling member 28" is manufactured outside the mould 14 and is subsequently attached to the electric component unit 9" after which the electric component unit 9" and the cooling member 28" are inserted by a robot 20 into the housing 7".

It should be noted that the invention has been disclosed above only by three embodiments. Accordingly, the invention may be implemented in many various ways within the scope of the claims. Thus, the number of cavities in the mould may vary; the selected materials may vary; the parts of the electric component unit may vary and the electric component unit can be positioned as an unit (i.e. not necessary as separate components) into the housing; and the parts/components of the electric component unit, including the type of light source, may vary. Also the composition of the electro conductive compound may vary. Preferably the electro conductive compound is a thermoplastic mixed with copper fibres, but more generally it is a polymer mixed with metal. Instead of copper fibres, aluminium fibres or silver fibres can be used. This is also true for the thermally conductive compound.

## Claims

1. A method for manufacturing a watertight lamp comprising a housing (7, 7', 7"), a lens (8, 8', 8") attached to the housing, an electric component unit (9, 9', 9") comprising a light source (21, 21', 21"), and an outer connector (6, 6', 6") for connecting a power supply to the lamp, the method comprising the steps of injection moulding the lens, injection moulding the housing, inserting the electric component unit into the housing, and attaching the lens to the housing in a watertight manner, said method comprising
- a first moulding step comprising feeding a first plastic compound (18) into a first cavity (15) of a mould (14) comprising at least three cavities (15, 16, 17) and a second moulding step comprising feeding a second plastic compound (19) into a second cavity (16) of the mould (14) and producing by said moulding steps the injection moulded housing (7, 7', 7") and the injection moulded lens (8, 8', 8"), respectively, of the lamp,
- opening the mould (14) and inserting in the housing (7, 7', 7") the electric component unit (9, 9', 9") comprising the light source (21, 21', 21 "),
- closing the mould (14) and producing in a third moulding step conductive parts (4, 5, 4', 5', 4", 5") of the outer connector (6, 6', 6") to the lamp, by feeding into the closed mould an electro conductive compound (30) comprising a polymer, said conductive parts providing an electro conductive path from the connector to the electric component unit (9, 9', 9"), and
- a fourth moulding step comprising feeding a sealing compound (31) into a third cavity (17) of the mould (14) and thus producing a seal (12, 12', 12") which attaches the lens (8, 8', 8") to the housing (7, 7', 7") in a watertight manner.

2. A method as claimed in claim 1, wherein the electric component unit (9, 9', 9") is inserted by a robot (20).

3. A method as claimed in claim 1, wherein the electro conductive compound (30) comprises a thermoplastic mixed with copper fibres.

4. A method as claimed in claim 1, comprising a further moulding step comprising feeding a thermally conductive compound (32") to the lamp and thus producing a cooling member (28") attached to the electric component unit (9") for cooling the electric component unit, said cooling member comprising a heat emitting area (33").

5. A method as claimed in claim 1, wherein the first plastic compound (18) is ABS and the second plastic compound (19) is PMMA.

6. A method as claimed in claim 1, comprising feeding into the mould (14) electro conductive compound (30) and thus producing electro conductive paths (10, 11, 11', 10", 11") between the conductive parts (4, 5, 4', 5', 4", 5") of the connector (6, 6', 6") and the electric component unit (9, 9', 9")

7. A watertight lamp comprising a housing (7, 7', 7"), a lens (8, 8', 8") attached watertight to the housing, an electric component unit (9, 9', 9") comprising a light source (21, 21', 21"), and an outer connector (6, 6', 6") for connecting a power supply to the lamp, **characterized in that** the outer connector (6, 6', 6") comprises conductive parts (4, 5, 4', 5', 4", 5") of electro conductive compound (30) comprising a polymer, said conductive parts providing an electro conductive path to the electric component unit (9, 9', 9").

8. A lamp as claimed in claim 7, wherein the conductive parts (4, 5) each comprise a conductive pin for receiving a connector of a voltage supply wire.

9. A lamp as claimed in claim 7, wherein the conductive parts (4', 5', 4", 5") each comprise conductive members (25', 25") forming a zigzag path for receiving the voltage supply wire (26', 26").

10. A lamp as claimed in claim 9, wherein the conductive members (25', 25") each comprise a slot (27') for receiving the wire (26', 26").

11. A lamp as claimed in claim 10, wherein the voltage supply wire (26', 26") received by the conductive members (25', 25") and by the connector (6', 6") is sealed.

12. A lamp as claimed in any of the preceding claims 7-11, comprising electro conductive paths (10, 11, 10', 10", 11") made of electro conductive compound comprising a polymer, said electro conductive paths being positioned between the conductive parts (4, 5, 4', 5', 4", 5") of the connector (6, 6', 6") and the electric component unit (9, 9', 9") for electrically connecting the former to the latter.

13. A lamp as claimed in any on of the preceding claims 7-12, wherein the electro conductive compound (30) is a thermoplastic comprising copper fibres.

14. A lamp as claimed in claim 7, comprising a cooling member (28") made of a thermally conductive compound (31") and attached to the electrical component unit (9") for cooling the electric component unit, said cooling member (28") comprising a heat emitting surface (33").

15. A lamp as claimed in claim 7, wherein the housing (7, 7', 7") is made of ABS and the lens (8, 8', 8") is made of PMMA and the housing and the lens being seamlessly connected to each other by means of sealing (12, 12', 12").

## Patentansprüche

1. Verfahren zur Herstellung einer wasserdichten Lampe, aufweisend ein Gehäuse (7, 7', 7"), eine an dem Gehäuse festgelegte Linse (8, 8', 8"), eine eine Lichtquelle (21, 21', 21") aufweisende elektrische Bestandteils-Einheit (9, 9', 9"), und einen Außenanschluss (6, 6', 6") für den Anschluss einer Stromzufuhr an die Lampe, wobei das Verfahren die Schritte eines Abformens der Linse, eines Abformens des Gehäuses, eines Einsetzens der elektrischen Bestandteils-Einheit in das Gehäuse und eines Festlegens der Linse an das Gehäuse in einer wasserdichten Weise beinhaltet, wobei das Verfahren aufweist:
- einen ersten Abformschritt, umfassend das Zuführen eines ersten Kunststoffbestandteils (18) in einen ersten Hohlraum (15) einer Gießform (14), die mindestens drei Hohlräume (15, 16, 17) umfasst, und einen zweiten Abformschritt, umfassend ein Zuführen eines zweiten Kunststoffbestandteils (19) in einen zweiten Hohlraum (16) der Gießform (14), und Herstellen von jeweils des abgeformten Gehäuses (7, 7', 7") und der abgeformten Linse (8, 8', 8") der Lampe durch die besagten Abformschritte,
- Öffnen der Gießform (14) und Einsetzen der elektrischen Bestandteilseinheit (9, 9', 9") mit der Lichtquelle (21, 21', 21") in das Gehäuse (7, 7', 7"),
- Schließen der Gießform (14) und Herstellen von Anschlussteilen (4, 5, 4', 5', 4", 5") des Außenanschlusses (6, 6', 6") für die Lampe in einem dritten Abformschritt, indem ein ein Polymer umfassender elektrisch leitfähiger Bestandteil (30) in die geschlossene Gießform geführt wird, wobei die leitfähigen Teile einen elektrisch leitfähigen Weg von dem Anschluss an die elektrische Bestandteilseinheit (9, 9', 9") vorsehen, und
- einen vierten Abformschritt, der das Zuführen eines Abdichtungsbestandteils (31) in einen dritten Hohlraum (17) der Gießform (14) umfasst, wodurch eine Dichtung (12, 12', 12") erzeugt wird, die die Linse (8, 8', 8") in einer wasserdichten Weise an dem Gehäuse (7, 7', 7") festlegt.

2. Verfahren nach Anspruch 1, wobei die elektrische Bestandteils-Einheit (9, 9', 9") mittels einem Roboter (20) eingesetzt wird.

3. Verfahren nach Anspruch 1, wobei der elektrisch leitfähige Bestandteil (30) ein mit Kupferfasern gemischtes Thermoplastik aufweist.

4. Verfahren nach Anspruch 1, ferner aufweisend einen Abformschritt, der das Zuführen eines thermisch leitfähigen Bestandteil (32") zur Lampe aufweist, womit ein Kühlelement (28") hergestellt wird, das an der elektrischen Bestandteils-Einheit (9") zum Kühlen der elektrischen Bestandteils-Einheit festgelegt wird, wobei das Kühlelement einen Wärme emittierenden Bereich (33") hat.

5. Verfahren nach Anspruch 1, wobei der erste Kunststoffbestandteil (18) ABS ist, und der zweite Kunststoffbestandteil (19) PMMA ist.

6. Verfahren nach Anspruch 1, umfassend ein Zuführen des elektrisch leitfähigen Bestandteils (30) in die Gießform (14) und damit ein Herstellen eines elektrisch leitfähigen Weges (10, 11, 11', 10", 11") zwischen den leitfähigen Teilen (4, 5, 4', 5', 4", 5") des Anschlusses (6, 6', 6") und der elektrischen Bestandteils-Einheit (9, 9', 9").

7. Wasserdichte Lampe, aufweisend ein Gehäuse (7, 7', 7"), eine Linse (8, 8', 8"), die wasserdicht an dem Gehäuse festgelegt ist, eine elektrische Bestandteils-Einheit (9, 9', 9"), die eine Lichtquelle (21, 21', 21") aufweist, sowie einen Außenanschluss (6, 6', 6") zum Anschließen einer Stromzufuhr an die Lampe,
**dadurch gekennzeichnet, dass** der Außenanschluss (6, 6', 6") leitfähige Teile (4, 5, 4', 5', 4", 5") eines elektrisch leitfähigen Bestandteils (30) aufweist, der ein Polymer umfasst, wobei die leitfähigen Teile einen elektrisch leitfähigen Weg an die elektrische Bestandteils-Einheit (9, 9', 9") vorsehen.

8. Lampe nach Anspruch 7, wobei die leitfähigen Teile (4, 5) jeweils einen leitfähigen Anschluss-Pin zum Halten eines Anschlusses einer Stromzufuhrleitung aufweisen.

9. Lampe nach Anspruch 7, wobei die leitfähigen Teile (4', 5', 4", 5") jeweils leitfähige Elemente (25', 25") aufweisen, die einen Zickzackweg zum Aufnehmen der Stromzufuhrleitung (26', 26") bilden.

10. Lampe nach Anspruch 9, wobei die leitfähigen Elemente (25', 25") jeweils eine Einkerbung (27') zum Aufnehmen der Leitung (26', 26") aufweisen.

11. Lampe nach Anspruch 10, wobei die Stromzufuhrleitung (26', 26"), die von den leitfähigen Elementen (25', 25") und von dem Anschluss (6', 6") aufgenommen wird, abgedichtet ist.

12. Lampe nach einem der Ansprüche 7 - 11, aufweisend elektrisch leitfähige Wege (10, 11, 10', 10", 11 "), die aus einem ein Polymer aufweisenden elektrisch leitfähigen Bestandteil gefertigt sind, wobei die elektrisch leitfähigen Wege zwischen den leitfähigen Teilen (4, 5, 4', 5', 4", 5") des Anschlusses (6, 6', 6") und der elektrischen Bestandteils-Einheit (9, 9', 9") positioniert sind, um erstere an letztere elektrisch anzuschließen.

13. Lampe nach einem der vorangehenden Ansprüche 7 - 12, wobei der elektrisch leitfähige Bestandteil (30) ein Kupferfasern umfassendes Thermoplastik ist.

14. Lampe nach Anspruch 7, aufweisend ein Kühlelement (28"), das aus einem thermisch leitfähigen Bestandteil (31") gefertigt und an die elektrische Bestandteils-Einheit (9") zum Kühlen der elektrischen Bestandteilseinheit festgelegt ist, wobei das Kühlelement (28") eine Wärme emittierende Fläche (33") hat.

15. Lampe nach Anspruch 7, wobei das Gehäuse (7, 7', 7") aus ABS gefertigt ist und die Linse (8, 8', 8") aus PMMA gefertigt ist, und das Gehäuse und die Linse nahtlos miteinander mittels einer Abdichtung (12, 12', 12") verbunden sind.

## Revendications

1. Procédé de fabrication d'une lampe étanche comprenant un boîtier (7, 7', 7"), une lentille (8, 8', 8") fixée au boîtier, une unité de composant électrique (9, 9', 9") comprenant une source de lumière (21, 21', 21"), et un connecteur extérieur (6, 6', 6") destiné à connecter une alimentation à la lampe, le procédé comprenant les étapes de moulage par injection de la lentille, de moulage par injection du boîtier, d'insertion de l'unité de composant électrique à l'intérieur du boîtier et de fixation de la lentille au boîtier de manière étanche, ledit procédé comprenant
- une première étape de moulage comprenant l'introduction d'un premier composé en matière plastique (18) à l'intérieur d'une première cavité (15) d'un moule (14) comprenant au moins trois cavités (15, 16, 17) et une deuxième étape de moulage comprenant l'introduction d'un deuxième composé en matière plastique (19) à l'intérieur d'une deuxième cavité (16) du moule (14) et la production par lesdites étapes de moulage du boîtier moulé par injection (7, 7', 7") et de la lentille moulée par injection (8, 8', 8"), respectivement, de la lampe.
- l'ouverture du moule (14) et l'insertion dans le boîtier (7, 7', 7") de l'unité de composant électrique (9, 9', 9") comprenant la source de lumière (21, 21', 21"),
- la fermeture du moule (14) et la production dans une troisième étape de moulage de parties conductrices (4, 5, 4', 5', 4", 5") du connecteur extérieur (6, 6', 6") sur la lampe, en introduisant dans le moule fermé un composé électroconducteur (30) comprenant un polymère, lesdites parties conductrices fournissant un trajet électroconducteur du connecteur à l'unité de composant électrique (9, 9', 9") et
- une quatrième étape de moulage comprenant l'introduction d'un composé d'étanchéité (31) à l'intérieur d'une troisième cavité (17) du moule (14) et donc la production d'un joint d'étanchéité (12, 12', 12") qui fixe la lentille (8, 8', 8") au boîtier (7, 7', 7") de manière étanche.

2. Procédé selon la revendication 1, dans lequel l'unité de composant électrique (9, 9', 9") est insérée par un robot (20).

3. Procédé selon la revendication 1, dans lequel le composé électroconducteur (30) comprend une matière thermoplastique mélangée avec des fibres de cuivre.

4. Procédé selon la revendication 1, comprenant une autre étape de moulage comprenant l'introduction d'un composé thermoconducteur (32") dans la lampe et donc la production d'un élément de refroidissement (28") fixé à l'unité de composant électrique (9") en vue de refroidir l'unité de composant électrique, ledit élément de refroidissement comprenant une zone d'émission de chaleur (33").

5. Procédé selon la revendication 1, dans lequel le premier composé de matière plastique (18) est de l'ABS et le deuxième composé de matière plastique (19) est du PMMA.

6. Procédé selon la revendication 1, comprenant l'introduction dans le moule (14) d'un composé électroconducteur (30) et donc la production de trajets électroconducteurs (10, 11, 11', 10", 11") entre les parties conductrices (4, 5, 4', 5', 4", 5 ") du connecteur (6, 6', 6") et l'unité de composant électrique (9, 9', 9").

7. Lampe étanche comprenant un boîtier (7, 7', 7"), une lentille (8, 8', 8 ") fixée de façon étanche au boîtier, une unité de composant électrique (9, 9', 9") comprenant une source de lumière (21, 21', 21") et un connecteur extérieur (6, 6', 6") destiné à connecter une alimentation à la lampe, **caractérisée en ce que** le connecteur extérieur (6, 6' 6")comprend des parties conductrices (4, 5, 4', 5', 4", 5") d'un composé électroconducteur (30) comprenant un polymère, lesdites parties conductrices fournissant un trajet électroconducteur à l'unité de composant électrique (9, 9', 9").

8. Lampe selon la revendication 7, dans laquelle les parties conductrices (4, 5) comprennent chacune une tige conductrice destinée à recevoir un connecteur d'un fil de tension d'alimentation.

9. Lampe selon la revendication 7, dans laquelle les parties conductrices (4', 5', 4", 5") comprennent chacune des éléments conducteurs (25', 25") formant un trajet en zigzag destinés à recevoir le fil de tension d'alimentation (26', 26").

10. Lampe selon la revendication 9, dans laquelle les éléments conducteurs (25', 25") comprennent chacun une fente (27') destinée à recevoir le fil (26', 26").

11. Lampe selon la revendication 10, dans laquelle le fil de tension d'alimentation (26', 26") reçu par les éléments conducteurs (25', 25") et par le connecteur (6', 6") est scellé hermétiquement.

12. Lampe selon l'une quelconque des revendications précédentes 7 à 11, comprenant des trajets électroconducteurs (10, 11, 10', 10", 11") constitués d'un composé électroconducteur comprenant un polymère, lesdits trajets électroconducteurs étant positionnés entre les parties conductrices (4, 5, 4', 5', 4", 5 ") du connecteur (6, 6', 6") et l'unité de composant électrique (9, 9', 9") en vue de connecter électriquement les parties conductrices à l'unité de composant électrique.

13. Lampe selon l'une quelconque des revendications précédentes 7 à 12, dans laquelle le composé électroconducteur (30) est une matière thermoplastique comprenant des fibres de cuivre.

14. Lampe selon la revendication 7, comprenant un élément de refroidissement (28") constitué d'un composé thermoconducteur (31") et fixé à l'unité de composant électrique (9") en vue de refroidir l'unité de composant électrique, ledit élément de refroidissement (28") comprenant une surface d'émission de chaleur (33").

15. Lampe selon la revendication 7, dans laquelle le boîtier (7, 7', 7") est réalisé à partir d'ABS et la lentille (8, 8', 8") est réalisée à partir de PMMA et le boîtier et la lentille sont reliés sans soudure l'un à l'autre au moyen d'un joint d'étanchéité (12, 12', 12").
